# EUROPEAN PATENT APPLICATION

(11) **EP 2 472 621 A2**
(43) Date of publication of application: **04.07.2012**
(21) Application number: 11163267.5
(22) Date of filing: 20.04.2011
(51) Int. Cl.: H01L 41/09

(54) **Piezoelectric actuator**

(30) Priority: 30.12.2010 KR 20100139610; 14.01.2011 KR 20110004032
(71) Applicant: Samsung Electro-Mechanics Co., Ltd, Suwon Gyunggi-do 443-743 (KR)
(72) Inventor: Lee, Dong Kyun, 138-220, Seoul (KR); Lee, Jung Seok, 443-751, Gyunggi-do (KR); Park, Chuel Jin, 423-758, Gyunggi-do (KR); Oh, Won Seob, 443-470, Gyunggi-do (KR); Hwang, Jung Wook, 443-848, Gyunggi-do (KR); Paik, Ki Mun, 445-982, Gyunggi-do (KR)
(74) Representative: Heine, Christian Klaus

(57) **Abstract**

Disclosed herein is a piezoelectric actuator. According to the present invention, the manufacturing cost of the piezoelectric actuator can be reduced by simplifying the patterns of electrodes constituting the piezoelectric actuator, the piezoelectric actuator itself or an electronic product employing the piezoelectric actuator can be made smaller by using only planar simple translational movement of the piezoelectric actuator, and the piezoelectric actuator capable of independently performing linear translational movement in two directions on the plane can be provided.

## Description

### CROSS REFERENCE TO RELATED APPLICATION

This application claims the benefit of Korean Patent Application Nos. 10-2010-0139610, filed on December 30, 2010 and 10-2011-0004032, filed on January 14, 2011, entitled "Piezoelectric Actuator" which is hereby incorporated by reference in its entirety into this application.

### BACKGROUND OF THE INVENTION

### 1. Technical Field

The present invention relates to a piezoelectric actuator.

### 2. Description of the Related Art

Recently, a piezoelectric actuator using a piezoelectric body is receiving attention as a new motor substituting for an electric motor. The piezoelectric actuator enables reciprocating vibration of a member subjected to friction, such as a rotor or the like, by generating minute vibration in a piezoelectric sheet, and transmitting this minute vibration to the member subjected to friction by using contact friction between a friction member attached on the piezoelectric sheet and the rotor (or a slider). This piezoelectric motor has more advantages such as a high energy density, a fast response speed, less noise, and the like, in comparison with a motor of the prior art.

A piezoelectric actuator of the prior art relates to a piezoelectric body vibrating while tracing an ellipse overall by merging vertical-directional vibration movement and horizontal-directional vibration movement.

The piezoelectric actuator according to the prior art needed to laminate two or more piezoelectric sheets having different vibration directions in order to embody a piezoelectric body having an elliptical trace, and needed to form an electrode pattern capable of outputting vertical-directional vibration and an electrode pattern capable of outputting horizontal-directional vibration in each of the piezoelectric sheets. This caused an electric signal applied to each of the electrode pattern to be complicatedly set.

Further, in order to drive a piezoelectric actuator having a complicated structure due to complicated electrode patterns, it took somewhat long time to design the type of voltage application. This caused the manufacturing time and manufacturing cost of the piezoelectric actuator to be increased.

Moreover, as the structure of the piezoelectric actuator became complicated, electronic products employing the piezoelectric actuator became bulkier beyond necessity.

### SUMMARY OF THE INVENTION

The present invention has been made in an effort to provide a piezoelectric actuator in which the manufacturing cost can be reduced by simplifying an electrode pattern constituting the piezoelectric actuator, the piezoelectric actuator itself, or an electronic product employing the piezoelectric actuator can be made smaller by using only planar simple translational movement of the piezoelectric actuator, and translational movement in two directions can be independently performed on the plane.

According to a preferred embodiment of the present invention, there is provided a piezoelectric actuator including: a piezoelectric sheet; a first electrode pattern formed on one portion of one surface of the piezoelectric sheet; a second electrode pattern formed on the other portion of one surface of the piezoelectric sheet such that the second electrode pattern is electrically separated from the first electrode pattern; an electrode part formed on the other surface of the piezoelectric sheet; and a friction member formed on one surface of the piezoelectric sheet to be protruded from the piezoelectric sheet.

The electrode part may include a first electrode part formed on the other surface of the piezoelectric sheet correspondingly to the first electrode pattern, and a second electrode part formed on the other surface of the piezoelectric sheet correspondingly to the second electrode pattern such that the second electrode part is electrically separated from the first electrode part.

The piezoelectric sheet may be a piezoelectric laminate body formed by laminating a plurality of piezoelectric sheet units.

The piezoelectric sheet may be vibrated by applying voltages having a phase difference of 180 degrees to the first electrode pattern and the second electrode pattern, and the friction member may perform linear translational movement on a plane by the vibration of the piezoelectric sheet.

Voltages having the same phase may be applied to the first electrode pattern and the second electrode part and voltages having the same phase may be applied to the second electrode pattern and the first electrode part, and the voltages applied to the first electrode pattern and the second electrode pattern and the voltages applied to the second electrode pattern and the first electrode part may have a phase difference of 180 degrees, the piezoelectric sheet being vibrated by the application of voltages and the friction member performing linear translational movement on a plane by the vibration of the piezoelectric sheet.

The piezoelectric sheet may have a groove portion concavely depressed therein, and a portion of the friction member may be inserted into the groove portion.

The friction member may be formed between the first electrode pattern and the second electrode pattern, and the friction member may have a cross-section of a circular shape or a square shape.

The friction member may be made of ceramic material of Al₂O₃ or ZrO₂, tungsten carbide (WC) based hard metal, tool steel, or high speed steel.

The first electrode pattern and the second electrode pattern may be symmetrical with respect to a center point of the piezoelectric sheet.

The first electrode pattern and the second electrode pattern may have a square shape, a triangular shape, or a semi-circular shape.

According to another preferred embodiment of the present invention, there is provided a piezoelectric actuator including: a first piezoelectric sheet; a first electrode pattern formed on one portion of one surface of the first piezoelectric sheet and a second electrode pattern formed on the other surface of one surface of the first piezoelectric sheet such that the second electrode pattern is electrically separated from the first electrode pattern; a ground electrode formed on the other surface of the first piezoelectric sheet; a second piezoelectric sheet formed below the first piezoelectric sheet on which the ground electrode is formed; a third electrode pattern formed on one portion of a lower surface of the second piezoelectric sheet and a fourth electrode pattern formed on the other surface of the lower surface of the second piezoelectric sheet such that the fourth electrode pattern is electrically separated from the third electrode pattern; and a friction member formed on one surface of the first piezoelectric sheet.

The third electrode pattern and the fourth electrode pattern may be formed on the second piezoelectric sheet to cross over each other at an angle of 90 degrees based on the first electrode pattern and the second electrode pattern.

The first piezoelectric sheet and the second piezoelectric sheet may be vibrated in the first direction or the second direction in one body by applying voltages having a phase difference of 180 degrees to only the first electrode pattern and the second electrode pattern to allow the first piezoelectric sheet and the second piezoelectric sheet to perform translational movement in the first direction on the plane, and applying voltages having a phase difference of 180 degrees to only the third electrode pattern and the fourth electrode pattern to allow the first piezoelectric sheet and the second piezoelectric sheet to perform translational movement in the second direction on the plane.

The first piezoelectric sheet may have a groove portion concavely depressed therein, and a portion of the friction member may be inserted into the groove portion.

The friction member may be formed between the first electrode pattern and the second electrode pattern, and the friction member may have a cross-section of a circular shape or a square shape.

The friction member may be made of ceramic material of Al₂O₃ or ZrO₂, tungsten carbide (WC) based hard metal, tool steel, or high speed steel.

The first electrode pattern and the second electrode pattern may be symmetrical with respect to a center point of the first piezoelectric sheet.

The first electrode pattern and the second electrode pattern may have a square shape, a triangular shape, or a semi-circular shape.

The third electrode pattern and the fourth electrode pattern may be symmetrical with respect to the center point of the second piezoelectric sheet.

The third electrode pattern and the fourth electrode pattern may have a square shape, a triangular shape, or a semi-circular shape.

### BRIEF DESCRIPTION OF THE DRAWINGS

FIGS. 1A and 1B are a perspective view and a cross-sectional view showing a structure of a piezoelectric actuator including a single layer of a piezoelectric sheet according to a first preferred embodiment of the present;
FIG. 2 is a perspective view showing a structure of a piezoelectric actuator including multiple layers of piezoelectric sheets according to a first preferred embodiment of the present invention;
FIGS. 3A to 3C are views for explaining the type in which electric signals are applied to the piezoelectric actuator according to the first preferred embodiment of the present invention;
FIGS. 4A to 4C are plane views showing structures of different kinds of electrode patterns formed on a piezoelectric sheet constituting the present invention;
FIGS. 5A to 5D are views showing plane and cross-section of respective shapes of different kinds of friction members constituting the present invention;
FIG. 6 is a perspective view showing the structure of a piezoelectric actuator according to a second preferred embodiment of the present invention;
FIG. 7 is a cross-sectional view showing a structure of the piezoelectric actuator shown in FIG. 6;
FIGS. 8A and 8B are views for explaining the type in which electric signals are applied to the piezoelectric actuator according to the second preferred embodiment of the present invention;
FIG. 9 is a plane view showing a principle of linear translational movement of a piezoelectric actuator;
FIG. 10 is a view simulating the movement form of the piezoelectric actuator according to the second preferred embodiment of the present invention; and
FIG. 11 is a diagram for explaining the manner in which electric signals are applied.

### DESCRIPTION OF THE PREFERRED EMBODIMENTS

Various objects, advantages and features of the invention will become apparent from the following description of embodiments with reference to the accompanying drawings.

The terms and words used in the present specification and claims should not be interpreted as being limited to typical meanings or dictionary definitions, but should be interpreted as having meanings and concepts relevant to the technical scope of the present invention based on the rule according to which an inventor can appropriately define the concept of the term to describe most appropriately the best method he or she knows for carrying out the invention.

Various objects, advantages and features of the invention will become apparent from the following description of embodiments with reference to the accompanying drawings. In the specification, in adding reference numerals to components throughout the drawings, it is to be noted that like reference numerals designate like components even though components are shown in different drawings. Further, when it is determined that the detailed description of the known art related to the present invention may obscure the gist of the present invention, the detailed description thereof will be omitted.

Hereinafter, preferred embodiments of the present invention will be described in detail with reference to the accompanying drawings.

### Piezoelectric actuator according to a first preferred embodiment of the present invention

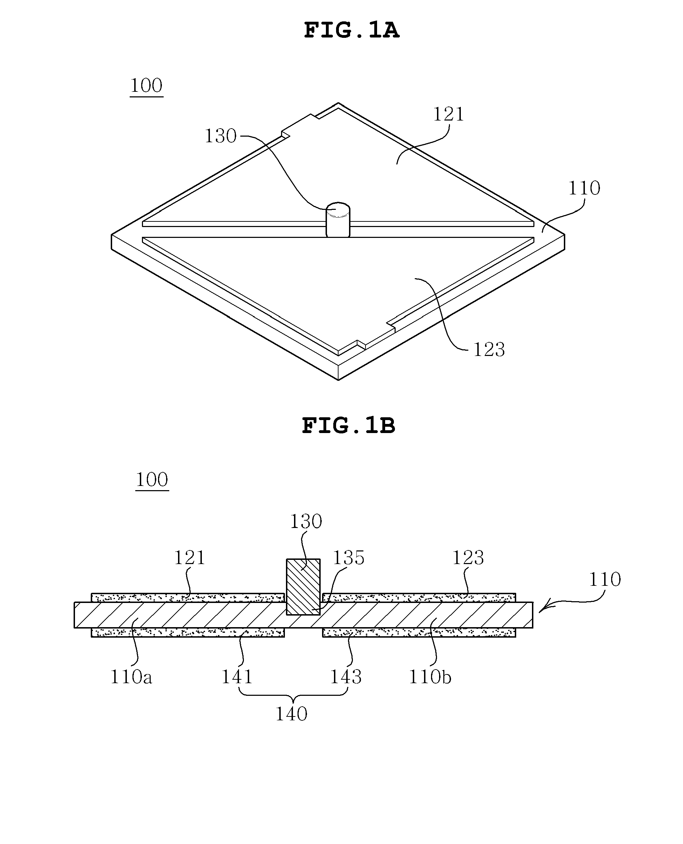

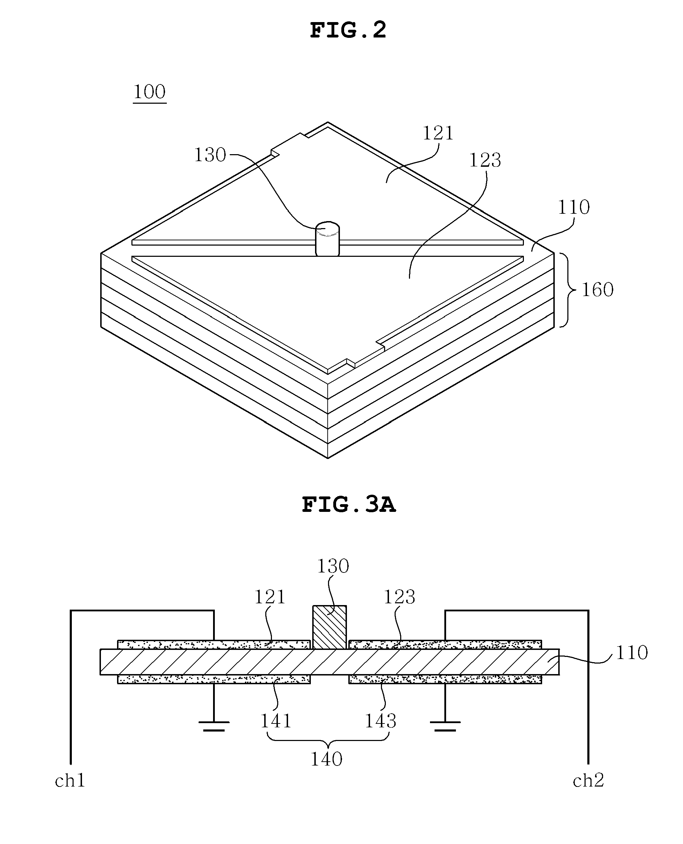

FIGS. 1A and 1B are a perspective view and a cross-sectional view showing a structure of a piezoelectric actuator including a single layer of a piezoelectric sheet according to a first preferred embodiment of the present; and FIG. 2 is a perspective view showing a structure of a piezoelectric actuator including multiple layers of piezoelectric sheets according to a first preferred embodiment of the present invention.

As shown in FIGS. 1A and 1B, a piezoelectric actuator 100 according to this preferred embodiment consists of a piezoelectric sheet 110, a first electrode pattern 121 and a second electrode pattern 123 formed on the piezoelectric sheet 110, an electrode part 140, and a friction member 130.

The piezoelectric sheet 110 is a member for generating a driving force due to vibration through expansion and contraction thereof when voltages are applied to electrode patterns (the first electrode pattern 121 and the second electrode pattern 123), and the electrode patterns 121 and 123 are formed on one surface of the piezoelectric sheet 110. In the preset invention, a first vibration part 110a, which is a transformation region of the piezoelectric sheet 110 according to the condition of the voltage applied to the first electrode pattern 121, and a second vibration part 110b, which is a transformation region of the piezoelectric sheet 110 according to the condition of the voltage applied to the second electrode pattern 123, will be differentiated from each other for explanation. In other words, the piezoelectric sheet 110 is divided into the first vibration part 110a and the second vibration part 110b. Meanwhile, the piezoelectric actuator 100 of the present invention may be embodied to a single layer of piezoelectric sheet 110 as well as a form in which two or more layers of piezoelectric sheets 110 are laminated as shown in FIG. 2. When the piezoelectric actuator 100 is embodied by multiple layers of piezoelectric sheets (a piezoelectric laminate body 160), an electronic product (e.g., a camera module for mobile phone) driven at a low voltage level is effectively drivable since an output with respect to the applied voltage, that is, a vibratory force is large. The piezoelectric sheet 110 is a member having a piezoelectric property, and for example, made of ceramic material, but not limited thereto. For example, any material known to the art may be employed for the piezoelectric sheet 110.

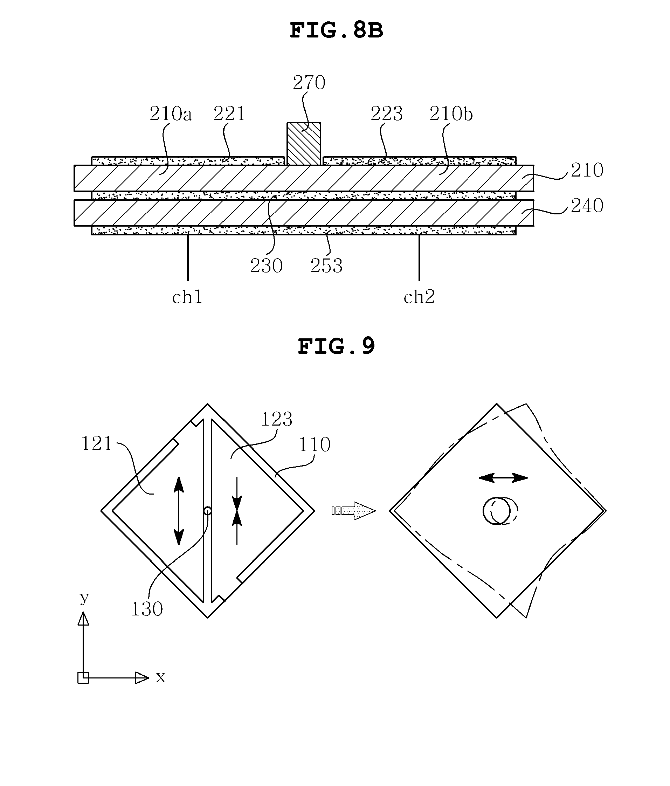

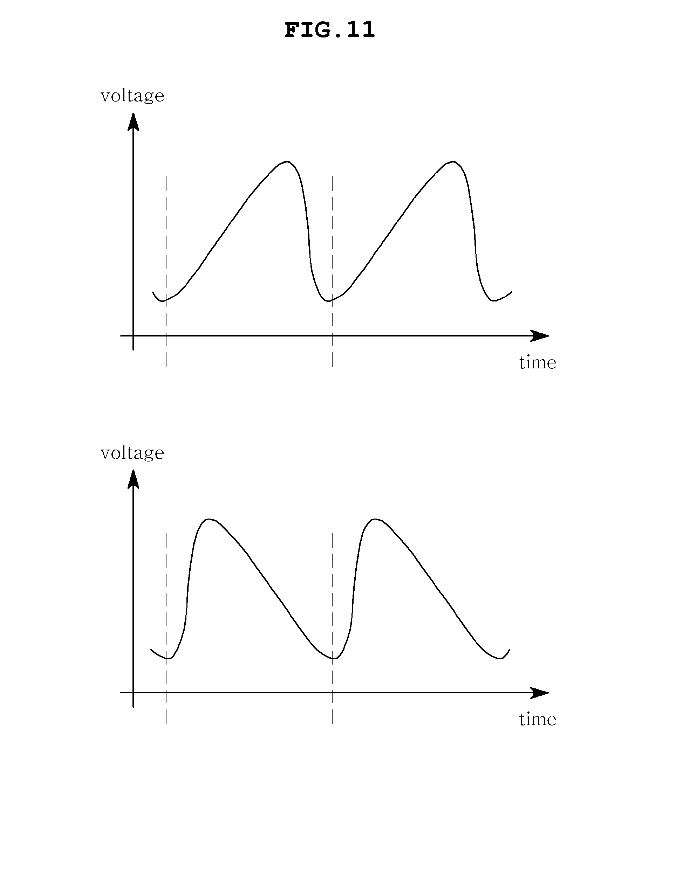

The driving type of the piezoelectric actuator 100 according to the present invention is as follows. First, as shown in FIG. 3A, voltages are applied to electrode patterns 121 and 123 while voltages having a phase difference of 180 degrees are applied to the first electrode pattern 121 and the second electrode pattern 123. Herein, the electrode parts 141 and 143 are in a ground. More specially, when electric signals having a phase difference are alternately applied to the first electrode pattern 121 formed on one side of one surface of the piezoelectric sheet 110 and the second electrode pattern 123 formed on the other side of one surface of the piezoelectric sheet 110, respective levels of the voltages applied to the electrode patterns 121 and 123 over time are shown in FIG. 11. For example, when a sine wave (having the positive sign in the early phase) is applied to ch1, a ground signal or a sine wave having a phase difference of 180 degrees with respect to the sine wave applied to ch1 is applied to ch2. On the contrary, in order to change the vibration direction inversely, a sine wave (having the negative sign in the early phase) is applied to ch1, and a ground signal or a sine wave having a phase difference of 180 degrees with respect to the sine wave applied to ch1 is applied to ch2. The piezoelectric actuator 100 of the present invention uses flexural vibration generated by contraction and expansion of the piezoelectric sheet 110. As described above, when the electric signals having a phase difference of 180 degrees (see, FIG. 11) are respectively applied to the first electrode pattern 121 and the second electrode pattern 123, the piezoelectric sheet 110, as shown in FIG. 9, performs translational movement in a plane direction (translational movement in an X-axial direction in case of FIG. 9) while the first vibration part 110a (FIG, 1B) is expanded and the second vibration part 110b (FIG. 1B) is contracted (the situation being the same with a case in which the first vibration part 110a is contracted and the second vibration part 110b is expanded according to the set value of electric signal). The friction member 130 is formed on one surface of the piezoelectric sheet 110 to transmit the vibratory force due to the linear translational movement of the piezoelectric sheet 110 to member subjected to friction (not shown; for example, a rotor or a slide).

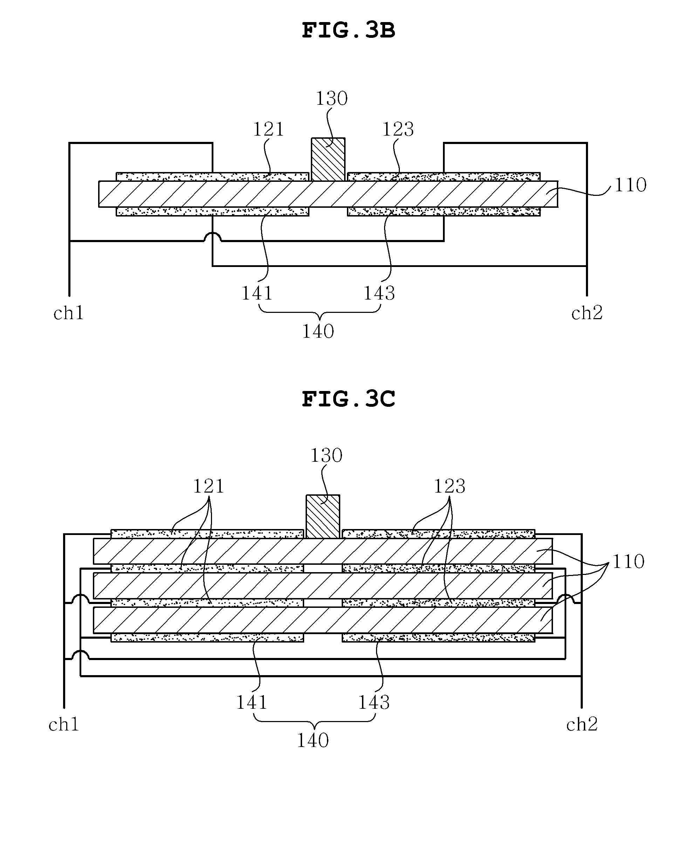

Meanwhile, the type in which voltages are applied as shown in FIG. 3B is preferable. First, the first electrode pattern 121 and the second electrode part 143 are electrically connected to each other, and the second electrode pattern 123 and the first electrode part 141 are electrically connected to each other. Therefore, voltages having the same phase are applied to the first electrode pattern 121 and the second electrode part 143, and voltages having the same phase are applied to the second electrode pattern 123 and the first electrode part 141. Then, voltages are respectively applied to the first electrode pattern 121 and the second electrode part 143, and the second electrode pattern 123 and the first electrode part 141. Herein, the respective voltages have a phase difference of 180 degrees. The type in which voltages having a phase difference of 180 degrees are applied is as described above. The first vibration part (110a in FIG. 1B) and the second vibration part (110b in FIG. 1B) are contracted/expanded by voltages, and thus, the piezoelectric sheet 110 is vibrated. The friction member 130 has a linear translational movement on the plane by the vibration of the piezoelectric sheet 110. FIG. 3C is a view for explaining the type in which voltages are applied to the piezoelectric actuator 100 shown in FIG. 2, and the type of voltage application is as described above.

The electrode patterns (the first electrode pattern 121 and the second electrode pattern 123) are formed on one surface of the piezoelectric sheet 110, and the electrode parts 140 are formed on the other surface of the piezoelectric sheet 110. Herein, the electrode parts 140 may be formed on the entire surface of the other surface of the piezoelectric sheet 110. Also, the electrode parts 140, as shown in FIG. 1B, may be divided into the first electrode part 141 and the second electrode part 143, and formed to correspond to the first electrode pattern 121 and the second electrode pattern 123. Herein, the first electrode pattern 121 and the second electrode pattern 123 may be formed to be symmetrical with respect to the center point of the piezoelectric sheet 110 (a crossing point of two diagonal lines on the piezoelectric sheet 110). The first electrode pattern 121 generates flexural (contraction or expansion) vibration in the first vibration part 110a according to the type of electric signal inputted, and the second electrode pattern 123 generates flexural (expansion or contraction) vibration in the second vibration part 110b according to the type of electric signal inputted.

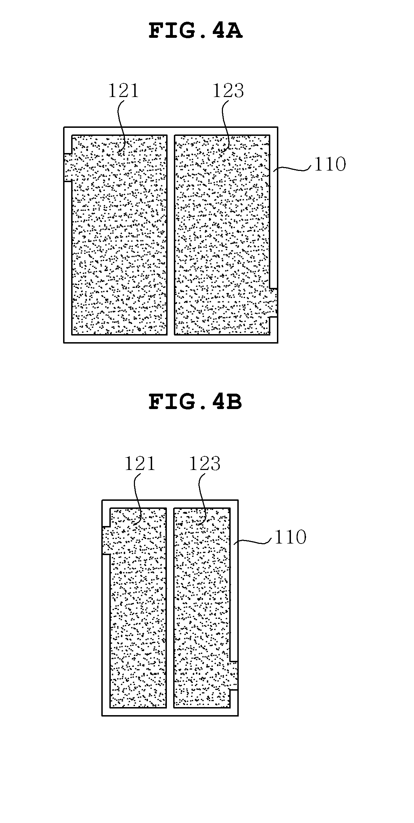

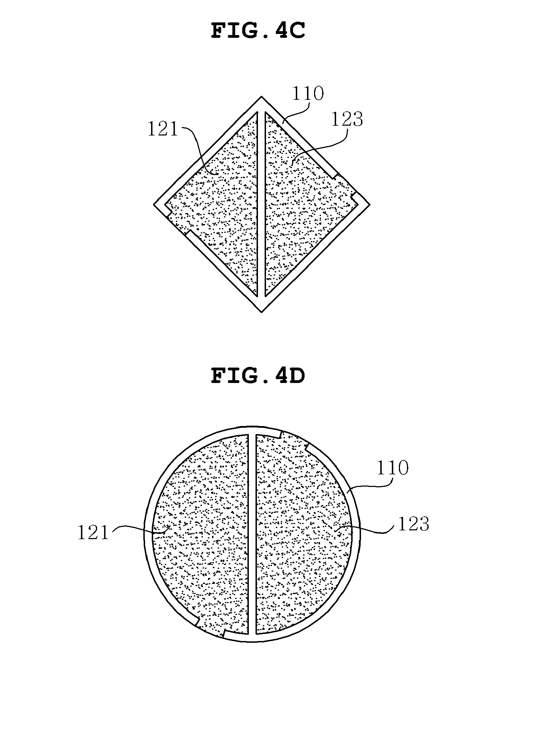

Meanwhile, as shown in FIGS. 4A to 4D, the first electrode pattern 121 and the second electrode pattern 123 have a square shape (FIGS 4A and 4B), a triangular shape (FIG. 4C), or a semi-circular shape (FIG. 4D). The electrode parts 140 (see, FIG. 1B) formed on the other surface of the piezoelectric sheet 110 may be also formed correspondingly to the arrangement form of the first electrode pattern 121 and the second electrode pattern 123.

The friction member 130 is a member for transmitting the vibration generated from the piezoelectric sheet 110 (the piezoelectric laminate body 160, in a case of FIG. 2) to the outside. There is a difference according to electronic products employing the piezoelectric actuator 100 according to the present invention, but, generally, a rotor or a slide may be contacted with the friction member 130. The friction member 130 may be attached on one surface of the piezoelectric sheet 110 by a bonding agent, and attached on a groove portion 135 (FIG. 1B) formed on the piezoelectric sheet 110 by a bonding agent. In other words, the groove portion 135 is formed on the piezoelectric sheet 110 to be concavely depressed, and a portion of the friction member 130 is inserted into the groove portion 135 to be attached to the piezoelectric sheet 110. Herein, the friction member 130 performs linear translational movement on the plane to transmit the vibratory force to member subjected to friction.

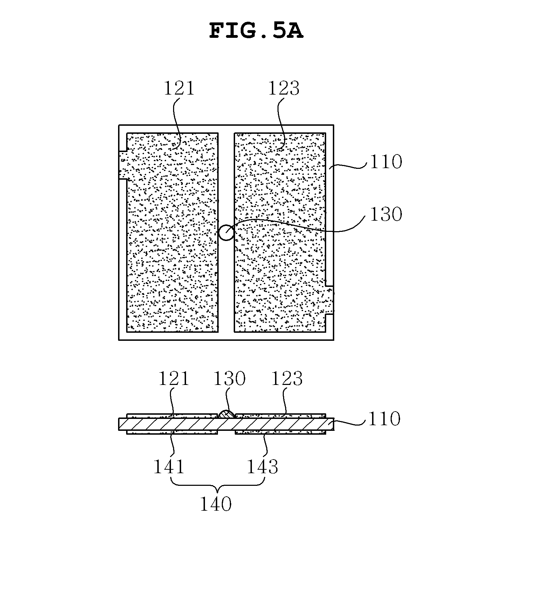

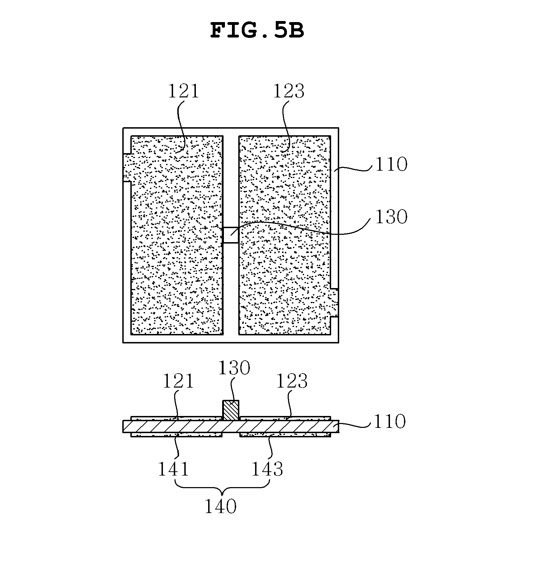

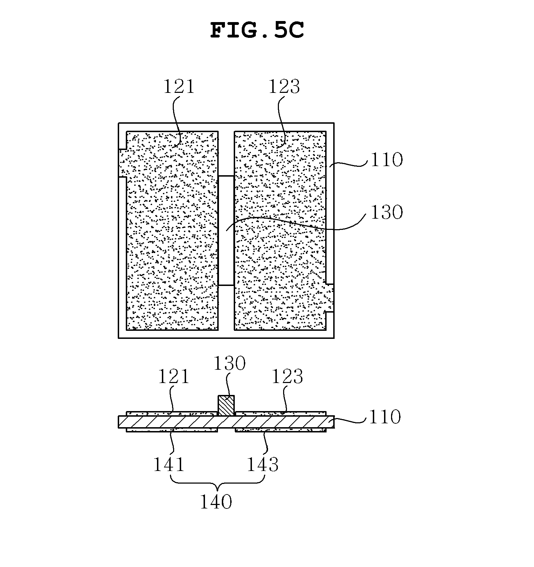

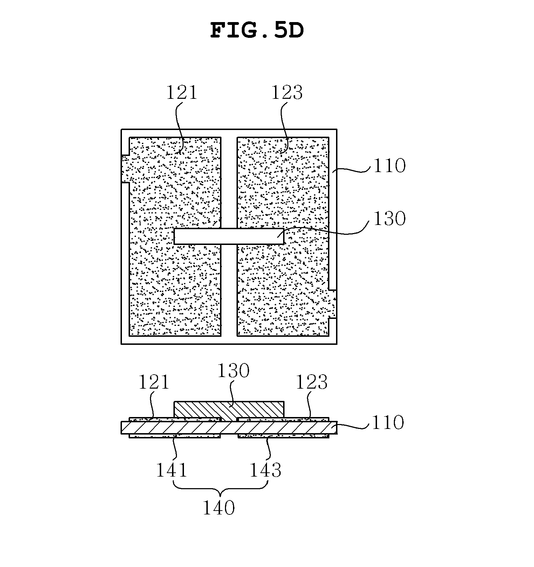

Meanwhile, as shown in FIGS. 1A and 1B, or FIG. 2, the friction member 130 is formed between the first electrode pattern 121 and the second electrode pattern 123. A cross-section of the friction member 130 has a circular shape or a square shape. The concrete shape of the friction member 130 is as shown in FIG. 5. In other words, the friction member 130 has a hemisphere (FIG. 5A) or hexahedral (FIG. 5B or FIG. 5C) shape. Also, the friction member 130 is formed to be protruded from the piezoelectric sheet 110 exposed between the first electrode pattern 121 and the second electrode pattern 123. Further, the friction member 130 may have a hexahedral shape (FIG. 5D) crossing the first electrode pattern 121 and the second electrode pattern 123. Besides, regardless of the shapes shown in FIGS. 5A to 5D, the shape of the friction member 130 may be changed to any shape in which a frictional force is transmitted to the member subjected to friction. Meanwhile, the friction member 130 is preferably made of material having a superior abrasion-resistant property and a large frictional coefficient. For the friction member 130, ceramic material, such as Al₂O₃, ZrO₂, or the like, or material, such as tungsten carbide (WC) based hard metal, tool steel, high speed steel, or the like, may be used. In addition, the friction member 130 may be made of material in which TiN, CrN, or WC is coated on general metal material to enhance the hardness.

### Piezoelectric actuator according to a second preferred embodiment of the present invention

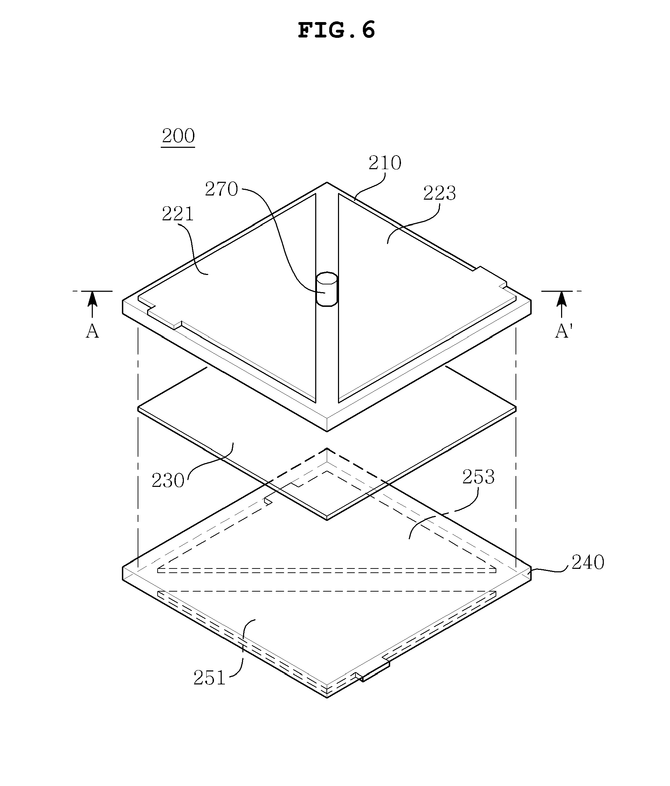

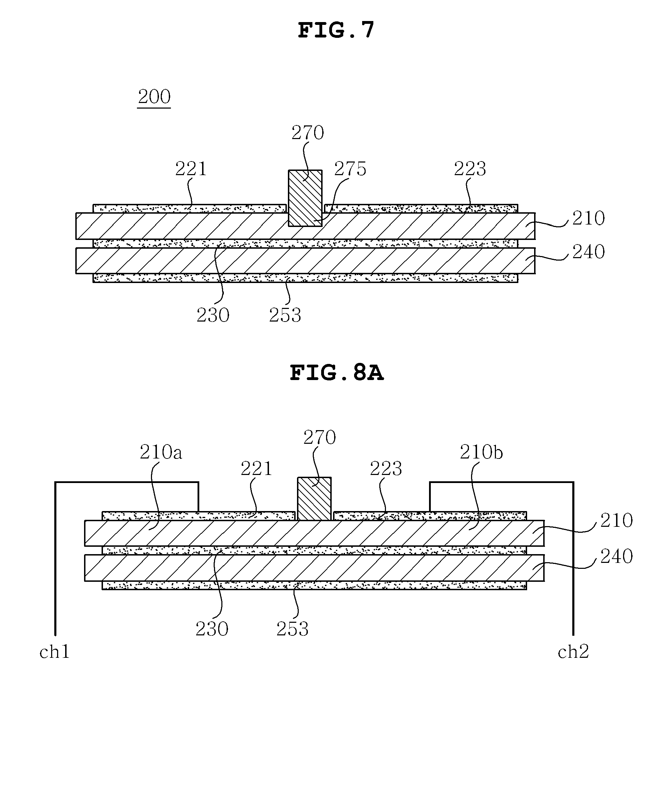

FIG. 6 and FIG. 7 are a perspective view and a cross-sectional view showing a structure of a piezoelectric actuator according to a second preferred embodiment of the present invention.

A piezoelectric actuator 200 according to a second preferred embodiment of the present invention includes a first piezoelectric sheet 210, a first electrode pattern 221 and a second electrode pattern 223 formed on one surface of the first piezoelectric sheet 210, a ground electrode 230 formed on the other surface of the first piezoelectric sheet 210, a second piezoelectric sheet 240 formed below the first piezoelectric sheet 210 on which the ground electrode 230 is formed, a third electrode pattern 251 and a fourth electrode pattern 253 formed on a lower surface of the second piezoelectric sheet 240, and a friction member 270 formed on one surface of the first piezoelectric sheet 210.

Herein, the third electrode pattern 251 and the fourth electrode pattern 253 are formed on the lower surface of the second piezoelectric sheet 240 to cross over each other at an angle of 90 degrees based on the first electrode pattern 221 and the second electrode pattern 223 (FIG. 6). In other words, the first piezoelectric sheet 210 is laminated on the second piezoelectric sheet 240 such that the first electrode pattern 221 and the second electrode pattern 223 cross over the third electrode pattern 251 and the fourth electrode pattern 253 formed on the second piezoelectric sheet 240 at an angle of 90 degrees in respect to the center point of the first piezoelectric sheet as an axis on a plane. This is for embodying a piezoelectric actuator 200 capable of performing translational movement in two directions, that is, a first direction or a second direction on a plane.

Since the detailed description related to the piezoelectric sheets (the first piezoelectric sheet 210, the second piezoelectric sheet 240), the electrode patterns 221, 223, 251, and 253, the ground electrode 230, and the friction member 270, which constitute the piezoelectric actuator 200 according to the second preferred embodiment of the present invention is the same as that of the piezoelectric actuator 100 (FIG. 1) according to the above-described first preferred embodiment, and thus, herein, repetitive description thereof will be omitted.

Meanwhile, the driving type of the piezoelectric actuator 200 according to the present preferred embodiment is as follows. The type of translational movement of the first piezoelectric sheet 210 or the second piezoelectric sheet 240 itself is the same as that of the piezoelectric actuator 100 (FIG. 1) according to the above-described first preferred embodiment. In other words, electric signals having a phase difference of 180 degrees are applied to the first electrode pattern 221 and the second electrode pattern 223 to generate linear translational movement by using expansion and contraction movements of the first vibration part 210a and the second vibration part 210b.

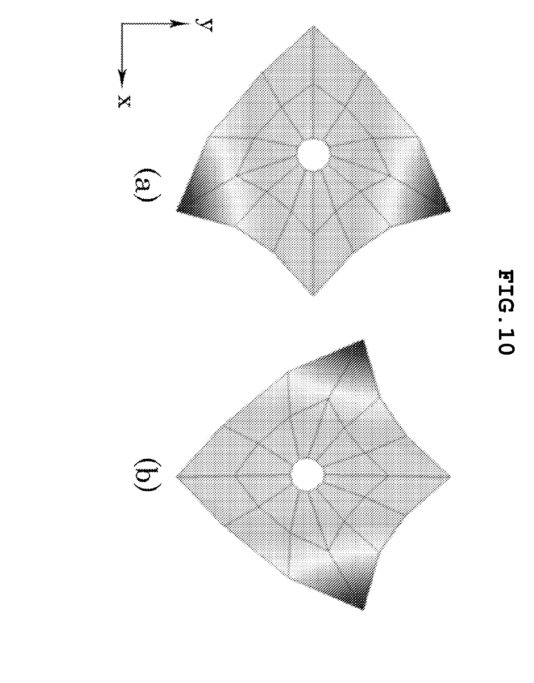

In the present preferred embodiment, voltages having a phase difference of 180 degrees to each other are applied to only the first electrode pattern 221 and the second electrode pattern 223, while electric signals are not applied to the third electrode pattern 251 and the fourth electrode pattern 253 (see, FIG. 8A). In this case, the second piezoelectric sheet 240 is attached to a lower surface of the first piezoelectric sheet 210 without separately generating vibration, and only the first piezoelectric sheet 210 performs translational movement in the first direction on the plane. Herein, the direction of the translational movement may be the first direction (that is, an X-axial direction, see, FIG. 10A). Meanwhile, on the contrary to this, voltages having a phase difference of 180 degrees to each other are applied to only the third electrode pattern 251 and the fourth electrode pattern 253, while electric signals are not applied to the first electrode pattern 221 and the second electrode pattern 223 (see, FIG. 8A). In this case, the first piezoelectric sheet 210 is attached to an upper surface of the second piezoelectric sheet 240 without separately generating vibration, and only the second piezoelectric sheet 240 performs translational movement in the second direction on the plane. Herein, the direction of the translational movement may be the second direction (that is, a Y-axial direction, see, FIG. 10B). The piezoelectric actuator 200 according to the second preferred embodiment of the present invention is characterized in that translational movements in the first direction or the second direction is independently induced in one piezoelectric actuator 200 by applying different electric signals. This bi-directional translational movement may be used in a camera module for cellular phone, and applied in an optical image stabilizer (OIS). Especially, downsizing of camera modules, simplifying of systems, and easiness of operation can be improved.

According to the present invention, the manufacturing cost of the piezoelectric actuator can be reduced by simplifying the patterns of electrodes constituting the piezoelectric actuator.

In addition, according to the present invention, the piezoelectric actuator itself, can be made smaller by using only planar simple translational movement of the piezoelectric actuator by embodying the piezoelectric actuator performing linear translational movement on the plane, and furthermore, the electronic product can be made smaller when the present invention is employed in the electronic product.

Further, according to the present invention, the piezoelectric actuator capable of performing linear translational movement in two directions on the plane can be embodied, by, when the piezoelectric actuator is embodied by laminating a pair of piezoelectric sheets on which electrode patterns are formed, laminating the electrode patterns formed on the respective piezoelectric sheets to cross over each other at an angle of 90 degrees and independently applying voltages to the respective piezoelectric sheets.

Although the preferred embodiments of the present invention have been disclosed for illustrative purposes, they are for specifically explaining the present invention and thus a piezoelectric actuator according to the present invention is not limited thereto, but those skilled in the art will appreciate that various modifications, additions and substitutions are possible, without departing from the scope and spirit of the invention as disclosed in the accompanying claims.

Accordingly, such modifications, additions and substitutions should also be understood to fall within the scope of the present invention.

## Claims

1. A piezoelectric actuator, comprising:
a piezoelectric sheet;
a first electrode pattern formed on one portion of one surface of the piezoelectric sheet;
a second electrode pattern formed on the other portion of one surface of the piezoelectric sheet such that the second electrode pattern is electrically separated from the first electrode pattern;
an electrode part formed on the other surface of the piezoelectric sheet; and
a friction member formed on one surface of the piezoelectric sheet to be protruded from the piezoelectric sheet.

2. The piezoelectric actuator as set forth in claim 1, wherein the electrode part includes a first electrode part formed on the other surface of the piezoelectric sheet correspondingly to the first electrode pattern, and a second electrode part formed on the other surface of the piezoelectric sheet correspondingly to the second electrode pattern such that the second electrode part is electrically separated from the first electrode part.

3. The piezoelectric actuator as set forth in claim 1, wherein the piezoelectric sheet is a piezoelectric laminate body formed by laminating a plurality of piezoelectric sheet units.

4. The piezoelectric actuator as set forth in claim 1, wherein the piezoelectric sheet is vibrated by applying voltages having a phase difference of 180 degrees to the first electrode pattern and the second electrode pattern, and
the friction member performs linear translational movement on a plane by the vibration of the piezoelectric sheet.

5. The piezoelectric actuator as set forth in claim 2, wherein voltages having the same phase are applied to the first electrode pattern and the second electrode part and voltages having the same phase are applied to the second electrode pattern and the first electrode part, and
the voltages applied to the first electrode pattern and the second electrode pattern and the voltages applied to the second electrode pattern and the first electrode part have a phase difference of 180 degrees,
the piezoelectric sheet being vibrated by the application of voltages
and
the friction member performing linear translational movement on a plane by the vibration of the piezoelectric sheet.

6. The piezoelectric actuator as set forth in claim 1, wherein the piezoelectric sheet has a groove portion concavely depressed therein, and a portion of the friction member is inserted into the groove portion.

7. The piezoelectric actuator as set forth in claim 1, wherein the friction member is formed between the first electrode pattern and the second electrode pattern, and the friction member has a cross-section of a circular shape or a square shape.

8. The piezoelectric actuator as set forth in claim 1, wherein the friction member is made of ceramic material of Al₂O₃ or ZrO₂, tungsten carbide (WC) based hard metal, tool steel, or high speed steel.

9. The piezoelectric actuator as set forth in claim 1, wherein the first electrode pattern and the second electrode pattern are symmetrical with respect to a center point of the piezoelectric sheet.

10. The piezoelectric actuator as set forth in claim 1, wherein the first electrode pattern and the second electrode pattern have a square shape, a triangular shape, or a semi-circular shape.

11. A piezoelectric actuator, comprising:
a first piezoelectric sheet;
a first electrode pattern formed on one portion of one surface of the first piezoelectric sheet and a second electrode pattern formed on the other surface of one surface of the first piezoelectric sheet such that the second electrode pattern is electrically separated from the first electrode pattern;
a ground electrode formed on the other surface of the first piezoelectric sheet;
a second piezoelectric sheet formed below the first piezoelectric sheet on which the ground electrode is formed;
a third electrode pattern formed on one portion of a lower surface of the second piezoelectric sheet and a fourth electrode pattern formed on the other surface of the lower surface of the second piezoelectric sheet such that the fourth electrode pattern is electrically separated from the third electrode pattern; and
a friction member formed on one surface of the first piezoelectric sheet.

12. The piezoelectric actuator as set forth in claim 11, wherein the third electrode pattern and the fourth electrode pattern are formed on the second piezoelectric sheet to cross over each other at an angle of 90 degrees based on the first electrode pattern and the second electrode pattern.

13. The piezoelectric actuator as set forth in claim 12, wherein the first piezoelectric sheet and the second piezoelectric sheet are vibrated in the first direction or the second direction in one body by applying voltages having a phase difference of 180 degrees to only the first electrode pattern and the second electrode pattern to allow the first piezoelectric sheet and the second piezoelectric sheet to perform translational movement in the first direction on the plane, and applying voltages having a phase difference of 180 degrees to only the third electrode pattern and the fourth electrode pattern to allow the first piezoelectric sheet and the second piezoelectric sheet to perform translational movement in the second direction on the plane.

14. The piezoelectric actuator as set forth in claim 11, wherein the first piezoelectric sheet has a groove portion concavely depressed therein, and a portion of the friction member is inserted into the groove portion.

15. The piezoelectric actuator as set forth in claim 11, wherein the friction member is formed between the first electrode pattern and the second electrode pattern, and the friction member has a cross-section of a circular shape or a square shape.

16. The piezoelectric actuator as set forth in claim 11, wherein the friction member is made of ceramic material of Al₂O₃ or ZrO₂, tungsten carbide (WC) based hard metal, tool steel, or high speed steel.

17. The piezoelectric actuator as set forth in claim 11, wherein the first electrode pattern and the second electrode pattern are symmetrical with respect to a center point of the first piezoelectric sheet.

18. The piezoelectric actuator as set forth in claim 11, wherein the first electrode pattern and the second electrode pattern have a square shape, a triangular shape, or a semi-circular shape.

19. The piezoelectric actuator as set forth in claim 11, wherein the third electrode pattern and the fourth electrode pattern are symmetrical with respect to the center point of the second piezoelectric sheet.

20. The piezoelectric actuator as set forth in claim 11, wherein the third electrode pattern and the fourth electrode pattern have a square shape, a triangular shape, or a semi-circular shape.
